Europäisches Patentamt

European Patent Office

Office européen des brevets

(11) Publication number: **0 363 055**
**A2**

## (12) EUROPEAN PATENT APPLICATION

(21) Application number: 89309711.3

(22) Date of filing: 25.09.89

(51) Int. Cl.5: **H01J 37/06 , H01J 1/16**

(30) Priority: 05.10.88 JP 251234/88

(43) Date of publication of application:
11.04.90 Bulletin 90/15

(84) Designated Contracting States:
DE FR GB

(71) Applicant: FUJITSU LIMITED
1015, Kamikodanaka Nakahara-ku
Kawasaki-shi Kanagawa 211(JP)

(72) Inventor: Sakamoto, Kiichi
22-5-704, Sugamo 4-chome Toshima-ku
Tokyo 170(JP)
Inventor: Oae, Yoshihisa
4-1-203, Miyamaedaira 2-chome Miyamae-ku
Kawasaki-shi Kanagawa 213(JP)
Inventor: Nishimura, Isao
Ogaki-so 10-19, Nakanobu 5-chome
Shinagawa-ku Tokyo 142(JP)
Inventor: Yasuda, Kiroshi
1505-1, Futoo-cho Kohoku-ku
Yokohama-shi Kanagawa 222(JP)

(74) Representative: Skone James, Robert Edmund
et al
GILL JENNINGS & EVERY 53-64 Chancery
Lane
London WC2A 1HN(GB)

(54) Electron gun and process of producing same.

(57) An electron gun used for electron-based projec-
tors, which comprises: a heater element (20) having
a surface provided with a blind hole (22) extending
therein; and a thermoelectron emitting element (21)
having a flat electron emitting surface and fitted in
the blind hole in such a manner that the electron
emitting surface is flush with or protrudes by a
predetermined distance (h) from the surface of the
heater element. Also disclosed is a process of pro-
ducing the electron gun.

Fig. 3

## ELECTRON GUN AND PROCESS OF PRODUCING SAME

The present invention relates to an electron gun used for an electron beam projector and the like, particularly an electron gun having a cathode which is a thermoelectron emitting element, and a process of producing same.

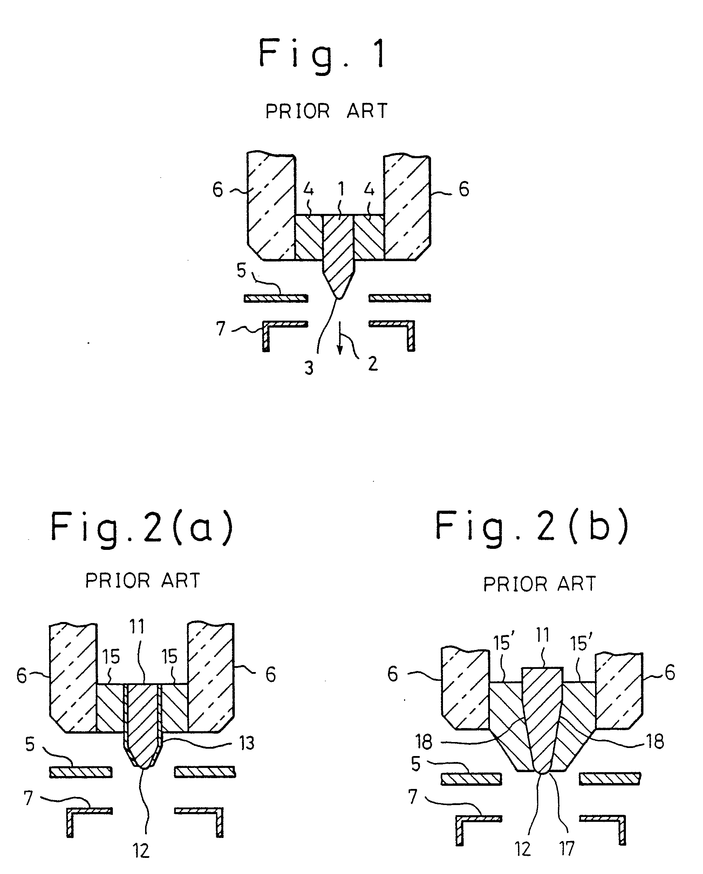

$LaB_6$ is used in the electron gun of an electron beam projector and the like as an electron emitting source having a high current capacity and a long service life, and Fig. 1 shows a basic structure of conventional electron guns provided with a thermoelectron emitting element of $LaB_6$. A thermoelectron emitting element of $LaB_6$ 1 has the form of a rod having a diameter of about 500 $\mu$m and an acute angled tip, and is held or clipped by graphite heater elements 4. Electric current applied across metal supports 6 causes the graphite heater elements 4 to generate heat, which heats up the $LaB_6$ thermoelectron emitter 1 so that thermoelectrons 2 are emitted from the acute angled tip or an electron emitting surface 3 of the $LaB_6$ thermoelectron emitter 1. These emitted electrons 2 are simultaneously controlled in terms of the current value thereof and converged by a grid 5, accelerated by an anode 7 to a predetermined level of kinetic energy, and discharged from an opening provided in the anode 7.

There are known an electron-beam projecting method in which a predetermined pattern is written or drawn by a raster scanning of a circular shaped electron beam having a Gaussian distribution, and a step-and-repeat type electron-beam projecting method in which a pattern is written by intermittently moving an electron beam having a predetermined shape and size, i.e., defined in a manner such that a pattern is drawn by a single stroke of electron beam. In these methods, to directly write a pattern on a substrate such as a silicon wafer having a diameter of several inches or more takes such a long time that it is difficult to obtain a desired throughput in the exposure process. To avoid this, a process has been developed, by which a predetermined pattern is written on an exposure mask by using an electron-beam projecting method, and the pattern written on the mask is then transferred onto a substrate with a light having a short wave length, such as an X-ray or synchrotron radiation.

Another process has been proposed by which a pattern is written on a mask by using an electron projecting method, and then transferred onto a substrate by using an electron beam. In this method, as in the miniaturizing projection method using an ordinary light, a semiconductor device pattern is divided into relatively large regional patterns which are then projected and respectively exposed on a substrate. This electron-beam projection method does not require the decomposition of a device pattern into a pattern element corresponding to the electron-beam shot, as in the aforementioned direct writing method, and thus relatively complicated patterns formed on a mask can be transferred at one time, which enables an improvement of the throughput in the exposure process. Moreover, a pattern is miniaturized while being projected, and even if the pattern is formed by an ordinary optical process using ultra-violet rays, the same level of resolution can be obtained on the exposed surface as that for patterns directly written by a step-and-repeat method.

The above method, however, requires a radiation of a uniform electron beam to a divided region containing a regional pattern to be transferred at one time, since a nonuniform electron beam density would result in a nonuniform distribution of an electron beam transmitting a mask and, in turn, an excessive or a poor exposure would occur within a pattern miniaturized and projected onto a substrate. This means that a predetermined pattern accuracy cannot be obtained due to a partial narrowing and/or broadening of the pattern width, etc. Namely, in the aforementioned direct writing method, the uniformity of the electron beam is significant only within a minute area exposed by each of the shots corresponding to the decomposed minute pattern elements, and does not substantially affect the size and accuracy of a pattern recomposed by the shots, but in the miniaturizing projection method, the uniformity of electron beam density within a relatively large area exposed at one time by a single shot is much more important.

To obtain a highly uniform electron beam, the cathode of an electron gun preferably has an as small as possible electron emitting surface area of the tip of $LaB_6$ thermoelectron emitting element 1 of Fig. 1, and usually has an acute angle. The $LaB_6$ thermoelectron emitting element 1 heated by the heater element 4, however, also emits electrons at the sides of the tip 3 and the emitted electron beam has a wide spread, which causes difficulty in obtaining a high uniformity.

To avoid this drawback, Japanese Unexamined Patent Publication (Kokai) No. 57-63744 proposed a structure in which, as shown in Fig. 2 (a), a $LaB_6$ chip (thermoelectron emitting element) 11 is coated with a coating for restricting the electron emission, leaving a desired electron emitting surface at the top thereof, and restricting the effective emitting area to the small area of the top or, in another way as shown in Fig. 2 (b), an integral block of a heater element 15' is provided with a chip insert hole 18 having an electron emitting hole 17 and the LaB$_6$ chip 11 is inserted in the hole 18 while projecting from the electron emitting hole 17, to restrict the electron emitting surface 12 to the top of the chip tip.

The above-mentioned conventional structure, however, has problems in that it is very difficult to coat the LaB$_6$ chip 11 with a different material, as shown in Fig. 2 (a), and leave a restricted area of the tip region which has been worked to have an acute angle, and that the coated material is consumed due to sublimation thereof and reaction with the LaB$_6$ chip heated to a high temperature. These problems of the conventional structure are mainly caused by a working limit, i.e., there is a limit to the reduction of the diameter of the LaB$_6$ chip 11. In the structure shown in Figs. 2 (a) and (b), the LaB$_6$ chip 11 has substantially the same length as the height of the heater element 15 or 15'. If a LaB$_6$ chip 11 is to be worked to such a size, it is difficult if the chip 11 has a diameter or sectional size of 500 $\mu$m or less. It is particularly difficult in the structure shown in Fig. 2 (b) to work the side of a LaB$_6$ chip 11 to provide a slant such that the chip is a tight fit in the chip insert hole 18.

The conventional structure has another problem in that LaB$_6$ sublimated from the exposed or projecting back end of the LaB$_6$ chip 11 adheres to a not-shown insulating member supporting the metal supports 6, and results in a leakage of the heating current. A large amount of leakage causes a protection system of a heating power supply to work, and thus a stable operation cannot be obtained.

According to one aspect of the present invention, there is provided an electron gun useful for electron-beam projectors, which comprises:
a heater element having a surface provided with a blind hole extending therein; and
a thermoelectron emitting element having a flat electron emitting surface and fitted in said blind hole in such a manner that said electron emitting surface is flush with or protrudes by a predetermined distance from said surface of said heater element.

According to a second aspect of the present invention, a process for producing an electron gun having a thermoelectron emitting element and heater element for heating the thermoelectron emitting element, which comprises the steps of:
forming a blind hole having a predetermined size in a surface of a first member composing a heater element; and
forming a second member composing a thermoelectron emitting element having a base portion fittable in said blind hole; and
fitting said base portion of said second member and then grinding said second member so that the ground surface of said second member is flush with or protrudes by a predetermined distance from said surface of said first member.

The present invention enables an improved uniformity of an electron beam to be obtained by using a thermoelectron emitting surface in the form of a flat surface. The flat thermoelectron emitting surface ensures the uniformity of the electron density of an electron beam, since most electrons are emitted in a single direction or in a direction perpendicular to the flat thermoelectron emitting surface, and since an electric field for leading the emitted electrons is applied in the direction perpendicular to an anode surface, the emitted electrons are evenly led toward the anode. When thermoelectrons are not emitted in a single direction, the emitted electron beam becomes broader as it moves away from the thermoelectron emitting surface, and a high uniformity of an electron beam cannot be obtained, and although the electron beam is usually converged by a lens or the like, the initial distribution of the electron density is not improved thereby.

Thus the present invention provides an electron gun in which the problems of the conventional structure are solved, ie. enables the use of a LaB$_6$ thermoelectron emitting element having a small electron emitting area while preventing a current leakage due to the sublimation of LaB$_6$, to ensure a highly uniform electron beam emission and increase the service life of an electron gun.

In one example of an electron gun, the base portion of a LaB$_6$ block is embedded in a graphite heater element, which enables a reduction of the diameter of the LaB$_6$ thermoelectron emitting element to a size as small as working of the block makes possible ie. the cathode area of an electron gun can be smaller than that of the conventional electron gun.

When an embedded LaB$_6$ block is used the sublimation of LaB$_6$ from the back end thereof is prevented, and therefore, a leakage of heating current does not occur at the surface of an insulating member supporting the graphite block, and thus a stable operation of the electron gun is ensured.

An example of an electron gun and method together with known guns are illustrated in the accompanying drawings, in which:-
Figure 1 is a partial sectional view showing a conventional electron gun in which a thermoelectron emitting element of LaB$_6$ is used;
Figure 2 is a partial sectional view showing another electron gun in which a thermoelectron emitting element of LaB$_6$ is used;
Figure 3 is partial sectional view showing the main portion of an electron gun according to one example of the present invention;
Figure 4 shows an example of a process for

forming and assemming a heater element and a thermoelectron emitting element according to the present invention; and,

Figure 5 shows an arrangement for transferring a pattern by using an electron beam.

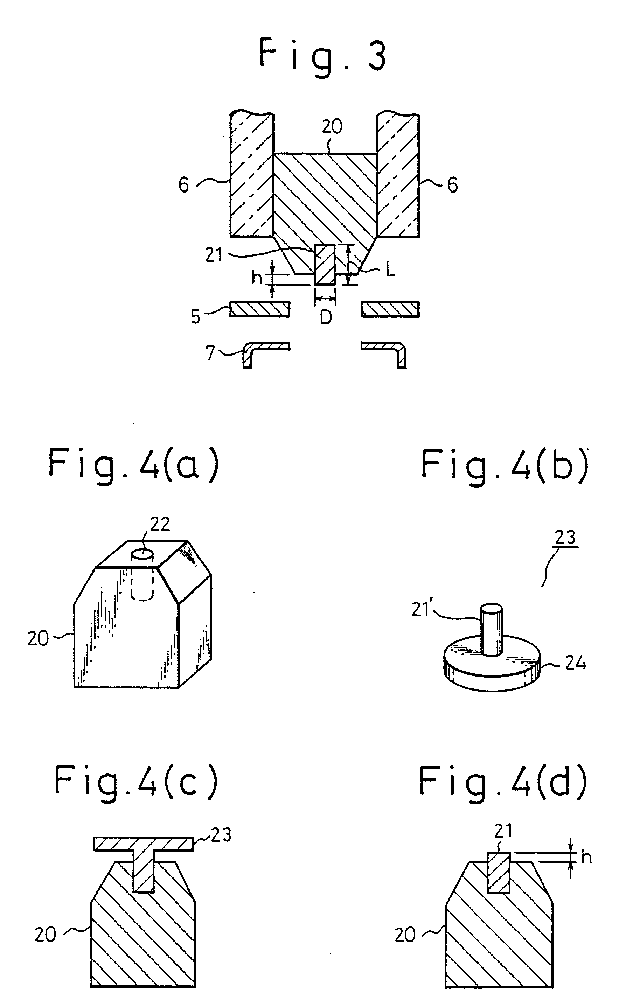

Figure 3 is a partial sectional view showing the main portion of an electron gun according to the present invention.

In the electron gun shown in Fig. 3, a heater element 20 consists of a graphite block, and a thermoelectron emitting element 21 consisting of $LaB_6$ is embedded in the heater element 20. More specifically, the thermoelectron emitting element 21 is, for example, in the form of a rod having a diameter (D) of 300 μm and a length (L) of 600 μm. The top portion of the thermoelectron emitting element 21 protrudes by a distance (h) of 3 to 10 μm from a surface of the heater element 20, the surface being worked as a flat surface. The extended base portion of the thermoelectron emitting element 21 is embedded in the heater element 20. Note, the base portion and the top portion compose a monolithic body.

The inventive structure, in which the thermoelectron emitting element 21 is embedded in the heater element 20, does not require the $LaB_6$ thermoelectron emitting element 1 or 11 to be clipped with the graphite heater element 4 or 15 in the manner required in the conventional electron gun shown in Fig. 1 or 2.

This enables the use of a $LaB_6$ thermoelectron emitting element having a diameter less than that of the conventional $LaB_6$ thermoelectron emitting element, as exemplified by the thermoelectron emitting element 21 having a diameter of 300 μm. Moreover, the extended base portion of the $LaB_6$ thermoelectron emitting element 21 need have only a length required for fixing same in the graphite heater element 20 or a length L-h, since the $LaB_6$ thermoelectron emitting element 21 per se does not substantially serve as a path for the heating current. The top portion and the extended base portion need not have a same diameter; for example, the extended base portion may have a diameter less than that of the top portion.

The tip of the $LaB_6$ thermoelectron emitting element 21 is worked as a flat surface, which serves as an electron emitting surface. The top portion of the $LaB_6$ thermoelectron emitting element 21 is protruded from the heater element 20 from the viewpoint of the consumption of $LaB_6$ due to sublimation during operation, to extend the cathode replacement term.

Therefore, the extrusion of the top portion is not necessarily required. The distance (h) of the extrusion is 3 to 10 μm, and therefore, the electron beam emitted from the side of the protruded top portion makes no substantial contribution to the electron beam.

By using a $LaB_6$ thermoelectron emitting element having a small diameter such as the $LaB_6$ thermoelectron emitting element 21, a uniform electron beam emission is obtained without working the tip to an acute angle such as in the conventional electron gun, and since the extended base portion of the $LaB_6$ thermoelectron emitting element 21 is embedded in the heater element 20, the sublimation of $LaB_6$ at the back end and the resulting contamination of an insulating support, which were unavoidable in the conventional $LaB_6$ thermoelectron emitting element 1, do not occur.

The flat electron emitting surface can be formed by grinding an integral body composed of a graphite heater element 20 and a $LaB_6$ thermoelectron emitting element 21 as will be described later, which is much easier than forming an electron emitting surface of the conventional electron gun.

Referring to Fig. 4, the forming of the heater element 20 and the $LaB_6$ thermoelectron emitting element 21 shown in Fig. 3 will be described below. As shown in Fig. 4 (a), the heater element 20 is formed by grinding a graphite block and then boring a blind hole 22 having, for example, a diameter of 300 μm and a depth of 600 μm, in a surface of the block. A member 23 shown in Fig. 4 (b) is prepared by grinding a block of $LaB_6$ single crystal. The member 23 is composed of a rod-shaped portion 21' having a diameter such that it is tightly fittable in the blind hole 22 and a length equal to or greater than the depth of the blind hole 22, and a grip head portion 24 having a diameter greater than that of the rod portion 21'. The grip head portion 24 is provided for the working and later handling of the member 23.

The rod portion 21' of the member 23 is tightly fitted into the blind hole 22 of the heater element 20 to assemble the member 23 and the heater element 20 as an integral body, as shown in Fig. 4 (c). Although the end of the rod portion 21' is preferably in contact with the bottom of the blind hole 22, any space left between the end and the bottom causes no problem. Thereafter, the grip head portion 24 is removed by grinding and the thus-exposed end of the rod portion 21' is then ground in such a manner that it protrudes from the surface of the heater element 20 by the aforementioned distance (h), which results in the formation of the structure of Fig. 4 (d), in which the heater element 20 is embedded in the $LaB_6$ thermoelectron emitting element 21, as also shown in Fig. 3.

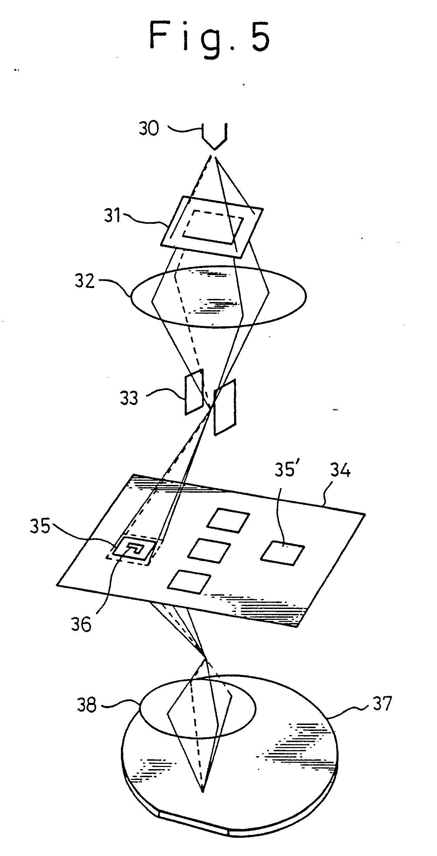

Figure 5 shows a main arrangement of an electron-beam projector provided with an electron gun according to the present invention. A process of transferring a semiconductor circuit pattern by using the projector will be described.

An electron beam emitted from an electron gun 30 is shaped by an aperture 31 into a rectangular section, converged by a convergence lens 32, deflected by a deflector 33, and irradiated onto a predetermined region 35 of a mask 34. The mask 34 is made of a metal such as tantalum (Ta), wolfram (W), etc., or a semiconductor such as silicon (Si), etc., in the form of a thin plate or a thin film. A magnified pattern 36 (for example, at a magnification of 100) of a desired semiconductor circuit pattern to be transferred onto a substrate 37, is formed on the regions 35. The pattern 36 is, for example, an opening, which transmits an electron beam and is surrounded by the above-mentioned mask material, i.e., a metal such as tantalum (Ta), wolfram (W) etc., or a semiconductor such as silicon (Si) etc.

The electron beam uniformly irradiated onto the predetermined region 35 is shaped to a pattern 36 upon passing through the mask 34. When an electron beam is irradiated onto another predetermined region 35' by deflecting the beam with the mask deflector 33, the corresponding pattern formed on the region 35' is selected to be transferred onto the substrate 37.

The electron beam transmitted through the mask 34 is converged by another not-shown convergence lens, led into the projector lens 38 where it is miniaturized by, for example, 1/100, deflected by another not-shown deflector provided in the vicinity of the projector lens 38, and projected onto a predetermined region of the substrate 37 to form the desired semiconductor circuit pattern corresponding to the pattern 36 at a predetermined position of the substrate 37 in a predetermined size. Along this sequence, patterns selected by the mask deflector 33 are successively miniaturized and projected onto predetermined regions on the substrate 37. The substrate is moved with an X-Y stage in accordance with need. This process transfers a desired semiconductor circuit pattern onto the whole required area on the substrate 37 and an ordinary lithographic process is then carried out to produce a semiconductor device.

This method of transferring a pattern with an electron beam does not require the decomposition of a device pattern into a pattern element corresponding to the electron-beam shot, as in the aforementioned direct writing method, and relatively complicated pattern formed on a mask can be transferred at one time, which enables an improvement of the throughput in the exposure process. Moreover, when a pattern to be formed on the substrate 37 has a size of 3 $\mu$m, the corresponding pattern 36 formed on the mask 34 has a magnified size of 300 $\mu$m, for example, which means that the pattern 36 may be formed on the mask 34 by an ordinary optical process using ultraviolet rays, and therefore, that the throughput can be also improved when manufacturing of the mask 34. The same level of resolution can be obtained on the exposed surface as that the patterns directly written by a step-and-repeat method.

As mentioned above, the present invention provides an electron gun which ensures an improved uniformity of the electron beam by using a flat thermoelectron emitting surface of a small ($LaB_6$) thermoelectron emitting element and has an extended service life, while improving the patterning accuracy in an electron-beam projection method in which a pattern formed on a mask is transferred by using an electron beam.

**Claims**

1. An electron gun comprising a heater element (20) having an aperture (22) within which is fitted a thermoelectron emitting element (21) characterised in that the aperture is a blind hole (22); and in that the thermoelectron emitting element (21) has a flat electron emitting surface and is fitted in the blind hole (22) in such a manner that the electron emitting surface is flush with or protrudes by a predetermined distance (h) from the adjacent surface of the heater element (20).

2. An electron gun according to claim 1, wherein the thermoelectron emitting element (21) comprises $LaB_6$ in the form of a rod having the flat electron emitting surface at one end thereof.

3. An electron gun according to claim 1 or claim 2, wherein one end of the thermoelectron emitting element (21) is in contact with the bottom of the blind hole (22).

4. An electron gun according to any of claims 1 to 3, wherein the heater element (20) is made of graphite.

5. A process for producing an electron gun having a thermoelectron emitting element (21) and a heater element (20) for heating the thermoelectron emitting element, the method comprising the steps of:
forming a blind hole (22) having a predetermined size in a surface of a first member (20) constituting the heater element;
forming a second member consituting the thermoelectron emitting element (21) having a base portion fittable in the blind hole (22); and
fitting the base portion of the second member (21) in the blind hole (22) of the first member and then grinding the second member so that the ground surface of the second member is flush with or protrudes by a predetermined distance (h) from the surface of the first member.

6. A process according to claim 5, wherein the second member (21) is formed as a rod having the base portion (21') and a grip head portion (24)

having a diameter greater than that of the base portion, the grip head portion being removed by grinding the second member.

7. A process according to claim 5 or claim 6, wherein the base portion (21') of the second member is fitted in the blind hole (22) so that the end of the base portion is in contact with the bottom of the blind hole.

# Fig. 1

PRIOR ART

# Fig. 2(a)

PRIOR ART

# Fig. 2(b)

PRIOR ART

# Fig. 3

# Fig.4(a)

# Fig.4(b)

# Fig.4(c)

# Fig.4(d)

# Fig. 5